# EUROPEAN PATENT APPLICATION

(11) **EP 4 597 579 A1**
(43) Date of publication of application: **06.08.2025**
(21) Application number: 23890761.2
(22) Date of filing: 14.11.2023
(51) Int. Cl.: H01L 31/0224

(54) **SILICON WAFER HAVING COPPER SEED LAYER ON SURFACE, MANUFACTURING METHOD FOR SILICON WAFER, AND SOLAR CELL**

(30) Priority: 14.11.2022 CN 202211422324
(71) Applicant: Tongwei Solar (Chengdu) Co., Ltd., Chengdu, Sichuan 610299 (CN)
(72) Inventor: XUE, Xiaodong, Chengdu, Sichuan 610299 (CN)
(74) Representative: Marks & Clerk LLP
(86) International application number: PCT/CN2023/131462
(87) International publication number: WO 2024/104328

(57) **Abstract**

Provided in the present application are a silicon wafer having a copper seed layer on the surface, a manufacturing method for the silicon wafer, and a solar cell. The manufacturing method for said silicon wafer comprises the following steps: providing a silicon wafer substrate; sequentially forming on the surface of the silicon wafer substrate an amorphous silicon layer and a transparent conductive film; and, by means of a physical vapor deposition method, depositing on the transparent conductive film a copper seed layer, the temperature of the physical vapor deposition being 20°C-35°C. By means of controlling the deposition temperature of the physical vapor deposition for forming the copper seed layer to be 20°C-35°C, the present application effectively reduces the damage of the physical vapor deposition process to film layers of the silicon wafer, and reduces the occurrence of black spots appearing during EL testing of solar cells, thereby improving the battery yield, and reducing the production cost of solar cells.

## Description

### CROSS-REFERENCE TO RELATED APPLICATIONS

This application claims priority to Chinese patent application No. 2022114223245, filed with Chinese patent office on November 14, 2022, entitled "SILICON WAFER HAVING COPPER SEED LAYER ON SURFACE, MANUFACTURING METHOD FOR SILICON WAFER, AND SOLAR CELL", the content of which is hereby incorporated by reference in its entirety.

### TECHNICAL FIELD

The present disclosure relates to the technical field of production of solar cells, particularly relates to a silicon wafer having a copper seed layer on a surface thereof, a manufacturing method for the silicon wafer, and a solar cell.

### BACKGROUND

Heterojunction cells, also referred to as HJT cells (Hetero-junction with Intrinsic Thin-layer), are regarded as the most promising solar cell technology following PERC (Passivated Emitter and Rear Cell). Compared to conventional crystalline silicon solar cell technology, the introduction of an amorphous silicon film allows both the front and back surfaces of the crystalline silicon substrate in a silicon heterojunction solar cell to achieve effective passivation, resulting in further improved surface passivation. Additionally, the amorphous silicon film prevents direct contact between the metal electrode and the silicon material, further reducing carrier recombination losses and enhancing conversion efficiency.

In the manufacturing process of heterojunction cells, the cells typically undergo the steps including: texturing and cleaning → CVD coating → PVD coating → electrode grid line formation. This manufacturing process is relatively short, with cell production generally completed in only about 2.5 hours, which saves a significant amount of time compared to conventional PERC and TOPCon (Tunnel Oxide Passivated Contact solar cell) technologies, which can take 8 to 10 hours.

HJT cell technology inherently offers advantages of high efficiency and substantial power generation. However, compared to the current mainstream PERC technology, the primary challenge facing HJT cells is their high costs. While the industry continues to enhance HJT conversion efficiency, reducing manufacturing costs to improve cost-effectiveness has become a top priority.

In the production process of HJT cells, after the copper seed layer is formed via PVD (Physical Vapor Deposition) on a TCO (transparent conductive oxide) film, black spots often appear in the electroluminescence (EL) test of the cells, which may impact cell yield and further increase the production costs of HJT cells.

Therefore, how to reduce the occurrence of EL black spots after the deposition of the copper seed layer in HJT cells to improve cell yield is an urgent issue that needs to be addressed in the field.

### SUMMARY

In view of this, there is a need to provide a silicon wafer having a copper seed layer on a surface thereof, a manufacturing method for the silicon wafer, and a solar cell, which can reduce the proportion of EL black spot in the cell deposited with the copper seed layer and improve the cell yield.

The technical solutions in the present disclosure are described below:

According to a first aspect of the present disclosure, a method for manufacturing a silicon wafer having a copper seed layer on a surface thereof is provided, including the following steps:
providing a silicon wafer substrate;
sequentially forming an amorphous silicon layer and a transparent conductive film on a surface of the silicon wafer substrate; and
depositing the copper seed layer on the transparent conductive film by a physical vapor deposition method, with a temperature of the physical vapor deposition being 20 °C to 35 °C.

In the above manufacturing method, by improving the process condition of the physical vapor deposition for forming the copper seed layer in manufacturing the silicon wafer, and controlling the deposition temperature of the physical vapor deposition and formation of the copper seed layer to be 20 °C to 35 °C, the damage to the film layer on the silicon wafer in the process of the physical vapor deposition is effectively reduced, the occurrence of the black spot in the EL test of the solar cell is decreased, the cell yield is increased, and the production costs of the solar cell is lowered.

In some embodiments, the temperature of physical vapor deposition is 29 °C to 30 °C. More preferably, the temperature of the physical vapor deposition is 30 °C. As such, the proportion of the black spot occurred in the EL test of the cell can be well reduced, further improving the cell yield.

In some embodiments, the copper seed layer has a thickness of 80 µm to 100 µm. As the copper seed layer has a thickness greater than that of the copper seed layer formed by the conventional manufacturing method, the cooper seed layer can be prevented from excessive thinning in the subsequent cleaning process, which is conducive to improving the electrical property of the solar cell.

In some the embodiments, the step of depositing the copper seed layer on the transparent conductive film by the physical vapor deposition method is performed in a sealed chamber mounted with an air filter device.

By disposing the physical vapor deposition chamber for depositing the copper seed layer in the sealed chamber provided with the air filter device, the amounts of organic matter and dust impurities adsorbed on the transparent conductive film can be effectively reduced, further reducing the occurrence of the black spot in the EL test of the solar cell and improving the cell yield.

In some embodiments, the air filter device includes one or more of an FFU air filter and a chemical filter.

In some the embodiments, an electrostatic discharge device is provided on the sealed chamber. By providing the electrostatic discharge device on the sealed chamber, the amounts of organic matter and dust impurities adsorbed on the transparent conductive film can be further reduced, thereby further reducing the occurrence of the black spot in the EL test of the solar cell and improving the cell yield.

In some embodiments, the electrostatic discharge device is an ion air knife.

In some embodiments, the ion air knife is provided at an inlet of a feeding door of the sealed chamber.

In some embodiments, after depositing the copper seed layer, the manufacturing method further includes the following step: alternately stacking the silicon wafers with sulfur-free papers.

In some embodiments, after alternately stacking the silicon wafers with the sulfur-free papers, the manufacturing method further includes the following steps:
grouping the stacked silicon wafers in sets of 70 to 80 pieces, placing hollow boards at both ends of each of the sets of the silicon wafers, and providing the sulfur-free paper between the hollow board and the silicon wafer.

In some embodiments, after providing the sulfur-free paper between the hollow board and the silicon wafer, the manufacturing method further includes the following steps:
bagging and plastic-sealing each of the sets of the silicon wafers in an anti-rust bag; and
packing the sets of the silicon wafers that have been plastic-sealed into a case.

By improving the packaging process for the silicon wafers deposited with the copper seed layers, the contact friction between the silicon wafers during transportation is reduced, further reducing the occurrence of the black spot in the EL test of the solar cell and improving the cell yield.

In some embodiments, the packing the sets of the silicon wafers that have been plastic-sealed into the case includes the following steps:
packing the sets of the silicon wafers that have been plastic-sealed into a packaging case provided with a plurality of internal grooves therein, with two of the sets of the silicon wafers packed into one of the internal grooves and provided with a vacuum box therebetween.

In this way, the structural configurations of the packaging case and the internal grooves can further reduce the contact friction between the silicon wafers during transportation is reduced, thereby further reducing the occurrence of the black spot in the EL test of the solar cell and improving the cell yield.

According to a second aspect of the present disclosure, a silicon wafer having a copper seed layer on a surface thereof is provided. The silicon wafer having the copper seed layer on the surface thereof is manufactured by the method for manufacturing the silicon wafer having the copper seed layer on the surface thereof according to the first aspect of the present disclosure.

According to a third aspect of the present disclosure, a solar cell is provided, including:
the silicon wafer having the copper seed layer on the surface thereof according to the second aspect of the present disclosure; and
a copper grid line provided on the copper seed layer on the surface of the silicon wafer.

### BRIEF DESCRIPTION OF THE DRAWINGS

In order to better describe and illustrate embodiments and/or examples of the present disclosure, reference may be made to one or more of the drawings. The additional details or examples used to describe the drawings should not be considered limiting of the scope of any one of the disclosed applications, the presently described embodiments and/or examples, and the best mode presently understood of these applications.
FIG. 1 is a schematic view showing the physical vapor deposition performed in a sealed chamber in a manufacturing method according to an embodiment of the present disclosure;
FIG. 2 is a flow chart of packaging silicon wafers deposited with copper seed layers in the manufacturing method according to an embodiment of the present disclosure;
FIG. 3 is a schematic view showing packaging of silicon wafers deposited with copper seed layers in the manufacturing method according to an embodiment of the present disclosure;
FIG. 4 is an EL test image of a solar cell with black spot defects;
FIG. 5 is an EL test image of a normal solar cell.

### Description of reference numerals:

10. sealed chamber; 20. physical vapor deposition chamber; 30. FFU air filter; 40. chemical filter; 50. sulfur-free paper; 60. hollow board; 70. anti-rust bag; 80. vacuum box; 90. packaging case; 100. silicon wafer having copper seed layer on surface thereof.

### DETAILED DESCRIPTION

In order to make the above objects, features, and advantages of the present disclosure more apparent and understandable, the specific implementations of the present disclosure are described in detail below. In the following description, numerous specific details are set forth in order to provide a thorough understanding of the present disclosure. However, the present disclosure can be implemented in many other ways different from those described herein, and those skilled in the art can make similar modifications without departing from the present disclosure. Therefore, the present disclosure is not limited to the specific embodiments disclosed below.

In addition, the terms "first" and "second" are only used for descriptive purposes and cannot be understood as indicating or implying relative importance or implicitly indicating the quantity of the indicated technical features. Therefore, the features defined by the "first" or "second" may explicitly or implicitly include at least one of the features. In the description of the present disclosure, the "plurality" means at least two, such as two, three, etc., unless otherwise clearly and specifically defined.

In the present disclosure, unless otherwise clearly specified and limited, the terms such as "installed", "connected", "connected", "fixed" be understood broadly. For example, it can be understood as a fixed connection, a detachable connection, or an integral connection; it could be understood as a mechanical connection or an electrical connection; it could be understood as a direct connection or an indirect connection by an intermediate medium; it could be understood as the internal communication between two elements or an interaction relationship between two elements, otherwise clearly and specifically defined. For those of ordinary skill in the art, the specific meanings of the above terms in the present disclosure can be understood according to specific situations.

Unless otherwise defined, all technical and scientific terms used herein have the same meaning as commonly understood by those skilled in the art to which the present disclosure pertains. The terms used in the description of the present disclosure herein are for the purpose of describing embodiments only and are not intended to limit the present disclosure. As used herein, the term "and/or" includes any and all combinations of one or more of the associated listed items.

In the conventional production process for HJT cells that utilize a copper grid line electrode, the deposition of a copper seed layer onto a TCO film via physical vapor deposition often results in the appearance of the black spot in the EL test of the cells, significantly impacting the yield of the cells and consequently leading to a substantial increase in the production costs of HJT cells.

In order to solve the above issues, an embodiment of the present disclosure provides a method for manufacturing a silicon wafer 100 having a copper seed layer on a surface thereof, including the following steps S100 to S400:
Step S100: providing a silicon wafer substrate.

The silicon wafer substrate can be an N-type silicon wafer or a P-type silicon wafer. Furthermore, the silicon wafer substrate can be textured and cleaned to form a pyramid-shaped texture structure on a surface of the silicon wafer substrate.

Step S200: sequentially forming an amorphous silicon layer and a transparent conductive film on the surface of the silicon wafer substrate.

In some embodiments, the amorphous silicon layer is deposited and formed on both a front side and a back side of the silicon wafer substrate. The transparent conductive film is deposited and formed on the amorphous silicon layer on each of the front side and the back side of the silicon wafer substrate. Specifically, the above amorphous silicon layer can be deposited and formed on the silicon wafer substrate by a chemical vapor deposition method, and the above transparent conductive film can be deposited and formed on the amorphous silicon layer by a physical vapor deposition method. In the present disclosure, the formation methods and process parameters for the amorphous silicon layer and the transparent conductive film are not specifically limited.

Step S300: depositing a copper seed layer on the transparent conductive film by a physical vapor deposition method.

In the physical vapor deposition process, a deposition temperature is controlled to be 20 °C to 35 °C.

In the conventional production process for HJT cells that utilize a copper grid line electrode, the copper seed layer is typically deposited and formed onto the transparent conductive film by a physical vapor deposition method, during which the temperature of the physical vapor deposition is typically around 180 °C. However, after the deposition and formation of the copper seed layer at this temperature of the physical vapor deposition, the black spot often occurs in the EL test of cells, resulting in a high rate of defective isolation of cells.

After the deposition and formation of the copper seed layer using the conventional method, one reason for the occurrence of the black spot in the EL test of cells is the relatively high temperature of the physical vapor deposition of the copper seed layer, which causes failure in formation of a good ohmic contact between the copper seed layer and the silicon wafer substrate. Consequently, when the silicon wafer is left for a period of time, the black spot will appear in the EL test. Through repeated experiments, the inventors of the present disclosure have found that in the process of the physical vapor deposition and formation of the copper seed layer, controlling the deposition temperature to between 20°C and 35°C effectively reduces damage to the film layer structure on the silicon wafer substrate during the physical vapor deposition, which effectively improves the ohmic contact between the copper seed layer and the silicon wafer substrate, thereby effectively reducing the occurrence of the black spot in the EL test and enhancing the yield of the cells.

It is to be understood that in the deposition and formation of the copper seed layer on the transparent conductive film by the physical vapor deposition method, the deposition temperature can be 20 °C, 22 °C, 24 °C, 26 °C, 28 °C, 30 °C, 32 °C, 35 °C, or any temperature value between the above temperature point values.

In some embodiments, the temperature of the physical vapor deposition is controlled to be 29 °C to 30 °C, more preferably, 30°C. As such, the occurrence of the black spot in the EL test of cells can be well reduced, further improving the yield of the cells.

In some embodiments, the copper seed layer has a thickness of 80 µm to 100 µm. In the present disclosure, the copper seed layer is formed with a thickness greater than that of the copper seed layer formed by the conventional manufacturing method. In this way, the cooper seed layer can be prevented from excessive thinning in the subsequent cleaning process, which is conducive to improving the electrical property of the solar cell.

In some embodiments, in the process of the physical vapor deposition and formation of the copper seed layer, a cleanliness of an environment of the physical vapor deposition is controlled at Class 10000 or higher, and a humidity level of the environment is controlled to be 27% to 33%.

In some embodiments, the step of depositing the copper seed layer on the transparent conductive film by the physical vapor deposition method is performed in a sealed chamber. Additionally, an air filter device is further mounted on the sealed chamber and configured to filter an organic matter, dust particles, or the like in the air in the sealed chamber.

It has been found through researches that, after the deposition and formation of the copper seed layer using the conventional method, another reason for the occurrence of the black spot in the EL test of the cells is that after the formation of the transparent conductive film (usually an ITO film), this film exhibits a certain electrostatic adsorption effect, allowing it to attract some organic matters and dust particles from the ambient air. After the deposition of the copper seed layer, these organic matters and dust particles cannot be removed and remain trapped between the transparent conductive film and the copper seed layer, leading to the formation of the EL black spot, also affecting the conductivity of the solar cell, and resulting in lower conversion efficiency of the solar cell.

To address the above issues, in the present disclosure, the physical vapor deposition chamber 20 for depositing the copper seed layer is disposed within a sealed chamber 10, and an air filter device is mounted on the sealed chamber 10 to purify the air in the sealed chamber 10, which can effectively remove organic matters and dust particles in the environment and effectively reduce the amounts of the organic matter and dust particle impurities on the transparent conductive film, thereby reducing the occurrence of the EL black spot in the cells.

In some embodiments, the air filter device includes one or more of an FFU air filter 30 and a chemical filter 40. In other words, the air filter device may include the FFU air filter 30 only, the chemical filter 40 only, or both the FFU air filter 30 and the chemical filter 40.

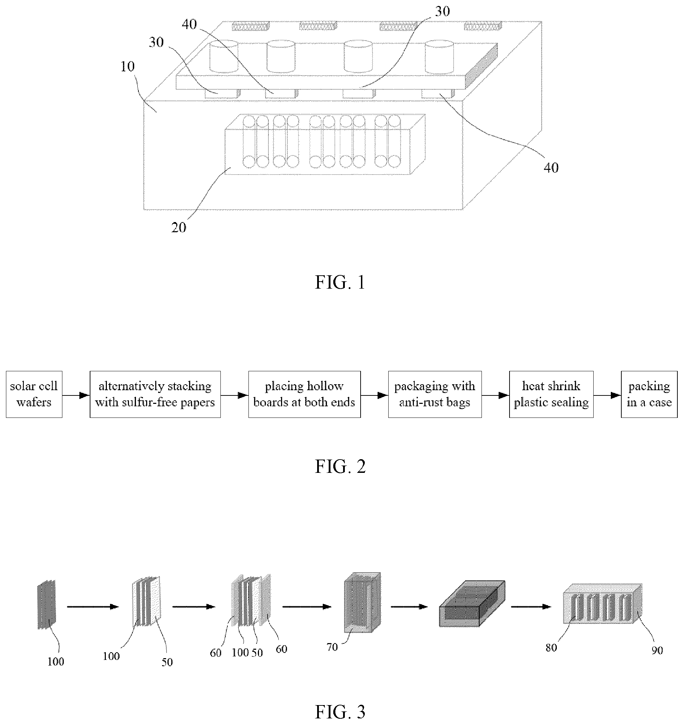

Referring to FIG. 1, in a specific example, the air filter device uses both the FFU air filter 30 and the chemical filter 40. Furthermore, both a plurality of FFU air filters 30 spaced apart from each other and a plurality of chemical filters 40 spaced apart from each other are provided. As such, the dust particle impurities in the environment can be effectively filtered out by the FFU air filter 30, and small droplets of organic matters in the environment can be effectively filtered out by the chemical filter 40, thereby improving the cleanliness of the environment of the physical vapor deposition of the copper seed layer, reducing the amounts of the organic matter and dust particle impurities on the transparent conductive film, and reducing the occurrence of the EL black spot in the cells.

In some embodiments, the sealed chamber 10 is further provided with an electrostatic discharge device therein. The provision of the electrostatic discharge device can reduce the electrostatic adsorption effect of the transparent conductive film, thereby further reducing the amounts of the organic matter and the dust particle impurities adsorbed on the transparent conductive film.

In a specific example, the electrostatic discharge device is an ion air knife provided in the sealed chamber 10. The provision of the ion air knife can effectively reduce the electrostatic adsorption effect of the transparent conductive film, achieving good effects of static electricity elimination and dust removal on the transparent conductive film. Specifically, the ion air knife can be mounted at an inlet of a feeding door of the sealed chamber 10.

Step S400: packaging the silicon wafer after depositing the copper seed layer.

Referring to FIG. 2 and FIG. 3, in some embodiments, the packaging of the silicon wafers having the copper seed layers on the surfaces thereof includes the following steps:

Step S401: alternately stacking the silicon wafers deposited with the copper seed layers with sulfur-free papers 50.

In the conventional manufacturing method, the silicon wafers deposited with the copper seed layers are typically stacked alternately with ordinary papers. Due to the high roughness of the ordinary papers, the papers can easily rub against the copper seed layers during the packing and transportation of the silicon wafers, leading to scratches on the copper seed layers. In the present disclosure, by alternately stacking sulfur-free papers 50 with the silicon wafers, the smooth surfaces of the sulfur-free papers 50 effectively prevent scratches on the copper seed layers. Furthermore, the alternately stacking of the silicon wafers with the sulfur-free papers 50 can also eliminate direct contact between the copper seed layers of adjacent silicon wafers which may cause frictions and impact the quality of the copper seed layers.

Step S402: grouping the stacked silicon wafers in sets of 70 to 80 pieces, placing a hollow board 60 at both ends of each of the sets of the silicon wafers, and providing the sulfur-free paper 50 between the hollow board 60 and the silicon wafer adjacent thereto to space apart the hollow board 60 and the silicon wafer adjacent thereto.

Step S403: bagging and plastic-sealing each of the sets of the silicon wafers in an anti-rust bag 70.

In some embodiments, the stacked silicon wafers are grouped into a plurality of sets. The hollow boards 60 are placed at both ends of each of the sets of the silicon wafers, respectively. Thereafter, each of the sets of the silicon wafers is packaged with the anti-rust bag 70. Thereafter, each of the sets of the silicon wafers is subjected to heat shrink plastic sealing. In this way, the cleanliness of the silicon wafers and an integrity of the copper seed layers can be better ensured.

Step S304: packing the sets of the silicon wafers into a case.

In some embodiments, the sets of the silicon wafers that have been plastic-sealed are packed into a packaging case 90 provided with a plurality of internal grooves therein. In each of the internal grooves, two sets of the silicon wafers are placed, with a vacuum box 80 placed between the two sets of the silicon wafers. Such arrangement can further prevent the contact between the silicon wafers during transportation, which may cause the EL black spot defects of the solar cells.

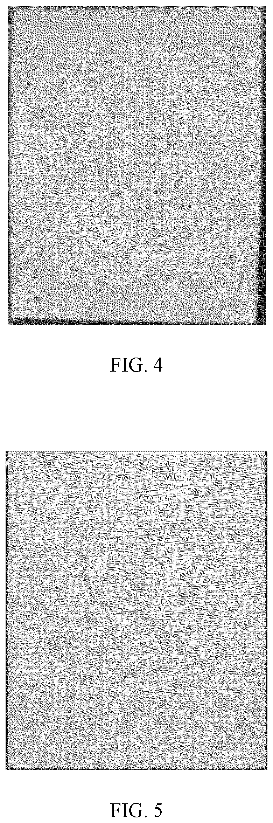

In general, in the present application, by improving the process conditions of the physical vapor deposition and formation of the copper seed layer in the manufacturing method of the silicon wafer, the design of the sealed chamber 10 for depositing the copper seed layer, and the packaging process, the damage caused by the physical vapor deposition process to the film layer on the silicon wafer can be effectively reduced, the amounts of the organic matter and dust impurities adsorbed on the transparent conductive film can be effectively reduced, and the contact friction between the silicon wafers during transportation can be effectively reduced. As a result, the occurrence of the black spot in the EL test of the solar cells is reduced from multiple aspects, leading to improved cell yield and decreased production costs of the solar cells. An EL test image of a defective solar cell with the black spot occurred in the EL test is shown in FIG. 4, while an EL test image of a normal solar cell is shown in FIG. 5.

Another embodiment of the present disclosure further provides a silicon wafer manufactured by the above-mentioned manufacturing method for the silicon wafer 100 having the copper seed layer on the surface thereof. The silicon wafer includes a silicon wafer substrate. An amorphous silicon layer is deposited and formed on both a front side and a back side of the silicon wafer substrate. A transparent conductive film is deposited and formed on the amorphous silicon layer. A copper seed layer is deposited and formed on the transparent conductive film.

In some embodiments, the silicon wafer substrate can be an N-type silicon wafer or a P-type silicon wafer.

In some embodiments, the amorphous silicon layer includes an intrinsic amorphous silicon layer and a doped amorphous silicon layer. The intrinsic amorphous silicon layer is disposed on the front side and the back side of the silicon wafer substrate. The doped amorphous silicon layer is disposed on a surface of the intrinsic amorphous silicon layer facing away from the silicon wafer substrate. Both the intrinsic amorphous silicon layer and the doped amorphous silicon layer can be manufactured by a chemical vapor deposition method.

In some embodiments, the front side and the back side of the silicon wafer substrate are provided with doped amorphous silicon layers in different doping types. That is to say, if the doped amorphous silicon layer on the front side of the silicon wafer substrate is a N-type doped amorphous silicon layer, then the doped amorphous silicon layer on the back side of the silicon wafer substrate is a P-type doped amorphous silicon layer. If the doped amorphous silicon layer on the front side of the silicon wafer substrate is a P-type doped amorphous silicon layer, then the doped amorphous silicon layer on the back side of the silicon wafer substrate is a N-type doped amorphous silicon layer.

In some embodiments, the transparent conductive film may be an ITO (indium tin oxide) film. The transparent conductive film can be manufactured by a physical vapor deposition method.

Another embodiment of the present disclosure further provides a solar cell, which includes the above silicon wafer 100 having the copper seed layer on the surface thereof in the present disclosure. A copper grid line electrode is formed on the copper seed layer on the surface of the silicon wafer by an electrical copper plating method. The silicon wafer having the copper seed layer on the surface thereof in the solar cell is manufactured by the above-mentioned manufacturing method of the present disclosure. Therefore, the occurrence of EL black spot defects in the solar cells of the present disclosure is significantly reduced compared to conventional solar cells, with the cell efficiency loss also greatly reduced.

The present disclosure will be further described below in conjunction with specific examples and comparative examples, which should not be construed as limiting the protection scope of the present disclosure.

### Example 1

A silicon wafer 100 having a copper seed layer on a surface thereof was manufactured by a method including the following steps:
1) proving a silicon wafer substrate.
   A surface of the silicon wafer substrate was textured and cleaned.
2) sequentially forming an amorphous silicon layer and a transparent conductive film on the surface of the silicon wafer substrate.
   The amorphous silicon layer was deposited on both a front aide and a back side of the silicon wafer substrate. The transparent conductive film was deposited on the amorphous silicon layer on both the front side and the back side of the silicon wafer substrate.
3) depositing a copper seed layer on the transparent conductive film by a physical vapor deposition method.
   In the process of the physical vapor deposition, a deposition temperature was controlled to be 20 °C, a deposition thickness of the copper seed layer was 90 µm, and a deposition power was 3.5 kw. In the process of the physical vapor deposition, a physical vapor deposition chamber 20 was placed in a sealed chamber 10, an ion air knife was provided at a feeding port of the sealed chamber 10, and an FFU air filter 30 and a chemical filter 40 spaced apart from each other were mounted on the sealed chamber 10. The solar cell wafer substrate was subjected to a static electricity elimination and dust removal treatment by the ion air knife when entering the sealed chamber 10. In the deposition process, the air in the environment in the sealed chamber 10 was purified by the FFU air filter 30 and the chemical filter 40.
4) packaging the silicon wafers deposited with the copper seed layers.

The silicon wafers deposited with the copper seed layers on the surfaces thereof were alternately stacked with the sulfur-free papers 50. The stacked silicon wafers were grouped in sets of 75 pieces, hollow boards 60 were placed at both ends of each of the sets of the silicon wafers, and the sulfur-free paper 50 is provided between the hollow board 60 and the silicon wafer. Each of the sets of the silicon wafers were bagged and plastic-sealed in an anti-rust bag 70. The sets of the silicon wafers that have been plastic-sealed were placed into a packaging case 90 provided with a plurality of internal grooves therein. In one internal groove, two sets of the silicon wafers are placed, and a vacuum box 80 was placed between the two sets of the silicon wafers.

A copper grid line electrode was formed by electrical plating on the copper seed layer of the silicon wafer 100 having the copper seed layer on the surface thereof manufactured in this example, thereby forming a solar cell. The solar cell was subjected to an EL test and its cell efficiency was tested using a sorting tester. The test results are shown in Table 1.

### Example 2:

The manufacturing method in this example is substantially the same as that in Example 1, except that in the process of the physical vapor deposition and formation of the copper seed layer, the deposition temperature was controlled to be 30 °C.

A copper grid line electrode was formed by electrical plating on the copper seed layer of the silicon wafer 100 having the copper seed layer on the surface thereof manufactured in this example, thereby forming a solar cell. The solar cell was subjected to an EL test and its cell efficiency was tested using the same method as in Example 1. The test results are shown in Table 1.

### Example 3:

The manufacturing method in this example is substantially the same as that in Example 1, except that in the process of the physical vapor deposition and formation of the copper seed layer, the deposition temperature was controlled to be 35 °C.

A copper grid line electrode was formed by electrical plating on the copper seed layer of the silicon wafer 100 having the copper seed layer on the surface thereof manufactured in this example, thereby forming a solar cell. The solar cell was subjected to an EL test and its cell efficiency was tested using the same method as in Example 1. The test results are shown in Table 1.

### Comparative Example 1:

The manufacturing method in this Comparative Example is substantially the same as that in Example 1, except that in the process of the physical vapor deposition and formation of the copper seed layer, the deposition temperature was controlled to be 15 °C.

A copper grid line electrode was formed by electrical plating on the copper seed layer of the silicon wafer 100 having the copper seed layer on the surface thereof manufactured in this example, thereby forming a solar cell. The solar cell was subjected to an EL test, and its cell efficiency was tested using the same method as in Example 1. The test results are shown in Table 1.

### Comparative Example 2:

The manufacturing method in this Comparative Example is substantially the same as that in Example 1, except that in the process of the physical vapor deposition and formation of the copper seed layer, the deposition temperature was controlled to be 90 °C.

A copper grid line electrode was formed by electrical plating on the copper seed layer of the silicon wafer 100 having the copper seed layer on the surface thereof manufactured in this example, thereby forming a solar cell. The solar cell was subjected to an EL test, and its cell efficiency was tested using the same method as in Example 1. The test results are shown in Table 1.

### Comparative Example 3:

The manufacturing method in this Comparative Example is substantially the same as that in Example 1, except that in the process of the physical vapor deposition and formation of the copper seed layer, the deposition temperature was controlled to be 155 °C.

A copper grid line electrode was formed by electrical plating on the copper seed layer of the silicon wafer 100 having the copper seed layer on the surface thereof manufactured in this example, thereby forming a solar cell. The solar cell was subjected to an EL test, and its cell efficiency was tested using the same method as in Example 1. The test results are shown in Table 1.

### Comparative Example 4:

The manufacturing method in this Comparative Example is substantially the same as that in Example 1, except that in the process of the physical vapor deposition and formation of the copper seed layer, the deposition temperature was controlled to be 180 °C.

A copper grid line electrode was formed by electrical plating on the copper seed layer of the silicon wafer 100 having the copper seed layer on the surface thereof manufactured in this example, thereby forming a solar cell. The solar cell was subjected to an EL test, and its cell efficiency was tested using the same method as in Example 1. The test results are shown in Table 1.

**Table 1 Test results of solar cells in examples and comparative examples**

| No. | Deposition temperature | Proportion of EL black spot defects | Cell efficiency |
|---|---|---|---|
| Example 1 | 20°C | 0.30% | 23.85% |
| Example 2 | 30°C | 0.25% | 24.02% |
| Example 3 | 35°C | 0.32% | 23.90% |
| Comparative Example 1 | 15°C | 28% | 23.75% |
| Comparative Example 2 | 90°C | 14.5% | 23.65% |
| Comparative Example 3 | 155°C | 24.3% | 23.25% |
| Comparative Example 4 | 180°C | 28% | 23.10% |

It can be seen from the test results in Table 1 that in the process of the physical vapor deposition and formation of the copper seed layer, controlling the deposition temperature within the range of 20°C to 35°C can effectively reduce the proportion of the EL black spot defects in the solar cells and improve the cell efficiency of the solar cells. Through data comparisons, it can be found that the higher the temperature of the physical vapor deposition of the copper seed layer, the greater the impacts on the cell defects and the cell efficiency in the production line. Whereas, the excessive low deposition temperature significantly increases the proportion of the EL black spot defects. The temperature between 20°C and 35°C represents the optimal condition for the production line.

The technical features of the above embodiments can be combined arbitrarily. In order to make the description concise, not all possible combinations of the technical features of the embodiments are described. However, as long as there is no contradiction in the combination of these technical features, the combinations should be considered as in the scope of the present disclosure.

The above embodiments are only several implementations of the present disclosure, and the descriptions are relatively specific and detailed, but they should not be construed as limiting the scope of the present disclosure. It should be understood by those of ordinary skill in the art that various modifications and improvements can be made without departing from the concept of the present disclosure, and all fall within the protection scope of the present disclosure. Therefore, the scope of protection of the present disclosure should be based on the attached claims, and the description and drawings can be used to interpret the contents of the claims.

## Claims

1. A method for manufacturing a silicon wafer having a copper seed layer on a surface thereof, comprising the following steps:
providing a silicon wafer substrate;
sequentially forming an amorphous silicon layer and a transparent conductive film on a surface of the silicon wafer substrate; and
depositing the copper seed layer on the transparent conductive film by a physical vapor deposition method, with a temperature of the physical vapor deposition being 20 °C to 35 °C.

2. The method for manufacturing the silicon wafer having the copper seed layer on the surface thereof according to claim 1, wherein the temperature of the physical vapor deposition is 29 °C to 30 °C.

3. The method for manufacturing the silicon wafer having the copper seed layer on the surface thereof according to claim 1 or 2, wherein the copper seed layer has a thickness of 80 µm to 100 µm.

4. The method for manufacturing the silicon wafer having the copper seed layer on the surface thereof according to any one of claims 1 to 3, wherein the step of depositing the copper seed layer on the transparent conductive film by the physical vapor deposition method is performed in a sealed chamber mounted with an air filter device.

5. The method for manufacturing the silicon wafer having the copper seed layer on the surface thereof according to claim 4, wherein the air filter device comprises one or more of an FFU air filter and a chemical filter.

6. The method for manufacturing the silicon wafer having the copper seed layer on the surface thereof according to claim 4 or 5, wherein the sealed chamber is provided with an electrostatic discharge device.

7. The method for manufacturing the silicon wafer having the copper seed layer on the surface thereof according to claim 6, wherein the electrostatic discharge device is an ion air knife.

8. The method for manufacturing the silicon wafer having the copper seed layer on the surface thereof according to claim 7, wherein the ion air knife is provided at an inlet of a feeding door of the sealed chamber.

9. The method for manufacturing the silicon wafer having the copper seed layer on the surface thereof according to any one of claims 1 to 8, after depositing the copper seed layer, further comprising the following step:
alternately stacking silicon wafers with sulfur-free papers.

10. The method for manufacturing the silicon wafer having the copper seed layer on the surface thereof according to claim 9, after alternately stacking the silicon wafers with the sulfur-free papers, further comprising the following steps:
grouping the stacked silicon wafers in sets of 70 to 80 pieces, placing hollow boards at both ends of each of the sets of the silicon wafers, and providing the sulfur-free paper between the hollow board and the silicon wafer.

11. The method for manufacturing the silicon wafer having the copper seed layer on the surface thereof according to claim 10, after providing the sulfur-free paper between the hollow board and the silicon wafer, further comprising the following steps:
bagging and plastic-sealing each of the sets of the silicon wafers in an anti-rust bag; and
packing the sets of the silicon wafers that have been plastic-sealed into a case.

12. The method for manufacturing the silicon wafer having the copper seed layer on the surface thereof according to claim 11, wherein the bagging each set of the silicon wafers that has been plastic-sealed comprises the following steps:
packing the sets of the silicon wafers that have been plastic-sealed into a packaging case provided with a plurality of internal grooves, with two of the sets of the silicon wafers packed into one of the internal grooves and a vacuum box provided therebetween.

13. A silicon wafer having a copper seed layer on a surface thereof, manufactured by the method according to any one of claims 1 to 12.

14. A solar cell, comprising:
the silicon wafer having the copper seed layer on the surface thereof according to claim 13; and
a copper grid line provided on the copper seed layer on the surface of the silicon wafer.
